# EUROPÄISCHE PATENTSCHRIFT

(11) **EP 1 269 625 B1**
(45) Veröffentlichungstag und Bekanntmachung des Hinweises auf die Patenterteilung: **21.06.2006**
(21) Anmeldenummer: 01929284.6
(22) Anmeldetag: 28.03.2001
(51) Int. Cl.: H03F 3/45

(54) **ELEKTRONISCHE AUSGANGSSTUFE**
ELECTRONIC OUTPUT MODULE
ETAGE DE SORTIE ELECTRONIQUE

(30) Priorität: 29.03.2000 DE 10016445
(43) Veröffentlichungstag der Anmeldung: 02.01.2003
(73) Patentinhaber: Infineon Technologies AG, 81669 München (DE)
(72) Erfinder: SCHROEDINGER, Karl, 14089 Berlin (DE); STIMMA, Jaro, 13587 Berlin (DE)
(74) Vertreter: Müller, Wolfram Hubertus
(86) Internationale Anmeldenummer: PCT/DE2001/001234
(87) Internationale Veröffentlichungsnummer: WO 2001/073943

(56) Entgegenhaltungen:
- EP-A- 0 525 656
- US-A- 4 859 961
- US-A- 5 493 253

## Beschreibung

Die Erfindung liegt auf dem Gebiet elektronischer Ausgangsstufen, insbesondere elektronischer Ausgangsstufen für CMOS-LVDS-Pegel (LVDS-low voltage differential signaling) zur Anwendung in analogen und digitalen Hochfrequenzschaltungen.

Aus der Veröffentlichung "Makrozellen für serielle Gbit/s Schnittstellen in 0.35µm CMOS", Tagungsband 8, ITG Fachtagung 3. - 4.3.98 Hannover, S. 107 - 112, ITG Fachbericht 147, ist eine Schaltung für eine elektronische Ausgangsstufe für digitale Signale mit einer Großsignalansteuerung bekannt. Die Ausgangsstufe umfaßt eine geregelte 'Push-Pull'-Stufe, wobei sich ein Hoch- und ein Niedrig-Pegel unabhängig voneinander regeln lassen. Die Regelung erfolgt i) individuell für den Hoch- und den Niedrig-Pegel mittels analoger Steuerspannungen von einem Referenzblock und eine digitale Skalierung oder ii) nur mittels digitaler Skalierung. Die digitale Skalierung kann über eine Rechnerschnittstelle eingestellt werden. Die bekannte Schaltung hat den Nachteil, daß für die Ansteuerung ein voller CMOS-Hub (z.B. 3,3 oder 5 Volt) und eine aufwendige Regelung für die Vorspannungsströme der vorgesehenen Differenzverstärkerstufen benötigt werden. Bei der bekannten Schaltung werden die Transistoren der elektronischen Ausgangsstufe als Schalter benutzt, so daß sie im ungesättigten Zustand betrieben werden.

Weiters wird in US 4,859,961 eine Verstärkersdraftung offenbart, bei den das Bandbreiten-Verstärkungsprodukt durch eine zweistufige Anordnung von Differenzverstärkern mit gemeinsamen Eingangssignal erweitert wird.

Aufgabe der vorliegenden Erfindung ist es, eine elektronische Ausgangsstufe für CMOS-LVDS-Pegel zu schaffen, die mit Kleinsignalen, vorzugsweise mit hochfrequenten Kleinsignalen angesteuert werden kann.

Diese Aufgabe wird erfindungsgemäß durch eine elektronische Ausgangsstufe gemäß Anspruch 1 gelöst.

Der wesentliche Vorteil, welcher mit der Erfindung gegenüber dem Stand der Technik erreicht ist, besteht darin, daß die vorgeschlagene elektronische Ausgangsstufe mit hochfrequenten Kleinsignalen (< 1 V) angesteuert werden kann. Dieses ist insbesondere dann von besonderem Vorteil, wenn Verstärkerschaltungen integriert sind, in denen kleine Hübe vorherrschen.

Weitere wesentliche Vorteile gegenüber der bekannten elektronischen Ausgangsstufe bestehen darin, daß Verlustleistung eingespart wird und auf eine Regelung der Stromquellen verzichtet werden kann.

Mit Hilfe einer geeigneten Dimensionierung der elektronischen Bauelemente der Ausgangsstufe kann ein Ausgangswiderstand von ca. 50 Ohm realisiert werden, wie es im LVDS-Standard gefordert wird und für Hochfrequenztreiber dringend zu empfehlen ist.

Die elektronische Ausgangsstufe weist im Vergleich zu reinen digitalen CMOS-Schaltungen weiterhin den Vorteil auf, daß keine hochfrequenten Spannungs- und Stromspitzen auftreten, die empfindliche analoge Schaltungen stören können. Bei der vorgeschlagenen Schaltung wird über die Stromquellen im wesentlichen ein Konstantstrom in Ausgangstreibern erzeugt. Die Transistoren werden hierbei im gesättigten Zustand betrieben.

Des weiteren wird aufgrund des reduzierten Eingangshubs das Entstehen von Störungen vermieden.

Vorteilhafte Weiterbildungen der Erfindung sind in den abhängigen Unteransprüchen offenbart.

Die Erfindung wird im Folgenden anhand eines Ausführungsbeispiels unter Bezugnahme auf eine Zeichnung näher erläutert. Hierbei zeigen:
- Figur 1: eine LVDS-Ausgangsstufe; und
- Figur 2: die LVDS-Ausgangsstufe nach Figur 1 mit einem Spiegelschaltkreis.

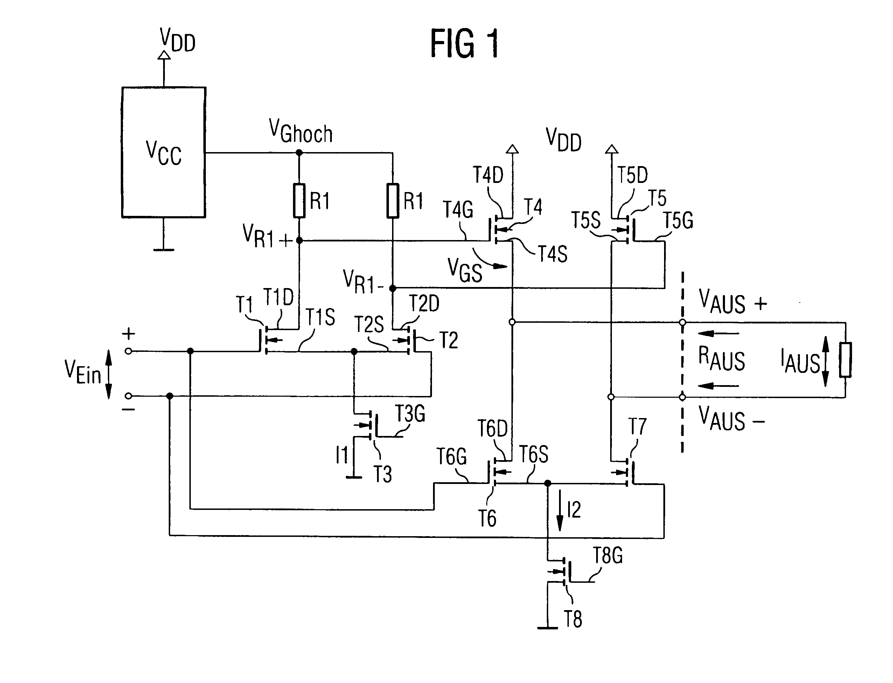

In Figur 1 ist eine LVDS-Ausgangsstufe dargestellt. Eine differenzielle Eingangsspannung V_{EIN} treibt eine Endstufe, die n-Kanal-MOS-Transistoren T6, T7 und T8 aufweist. Die Transistoren T6 und T7 sind gleichartig ausgebildet und als ein Differenzverstärker DV1 geschaltet, d.h. ihre Source-Anschlüsse T6S, T7S sind miteinander und mit einer Stromquelle T8 verbunden, die einen Strom I2 einprägt. Der Strom 12 wird mit einer geeigneten Spannung am Steueranschluß T8G des Transistors T8 eingestellt, so daß der Strom I2 etwas mehr als 3,5 mA beträgt. Am Steueranschluß T6G des Transistors T6 liegt der nicht invertierende Eingang V_{EIN}+ an. Am Steueranschluß T7G des Transistors T7 liegt der invertierende Eingang V_{EIN}- an. Ein Ausgangssignal V_{AUS} wird an den Drain-Anschlüssen T6D, T7D der Transistoren T6 und T7 abgegriffen, wobei an dem Drain-Anschluß T6D des Transistors T6 das invertierte Ausgangssignal V_{AUS}+ und an dem Drain-Anschluß T7D des Transistors T7 das nicht-invertierte Ausgangssignal V_{AUS}- abgegriffen wird.

Mit dem Drain-Anschluß T6D des Transistors T6 ist weiterhin ein Source-Anschluß T4S eines n-Kanal-MOS-Transistors T4 verbunden. An den Drain-Anschluß T7D des Transistors T7 ist ein Source-Anschluß T5S eines n-Kanal-MOS-Transistors T5 angeschlossen. Die Drain-Anschlüsse T4D, T5D der ebenfalls gleichartigen Transistoren T4 und T5 sind mit einem Versorgungsspannungspotential V_{DD} verbunden. An den Steueranschlüssen T4G, T5G der Transistoren T4 bzw. T5 liegt ein differenzielles Signal an, das aus einem Differenzverstärker DV2 stammt.

Der Differenzverstärker DV2 weist drei n-Kanal-MOS-Transistoren T1, T2, T3, zwei gleichwertige Widerstände R1 und einen Spannungsregelschaltkreis V_{CC} auf. Der Differenzverstärker DV2 dient dazu, die Eingangssignale V_{EIN}+ und V_{EIN}- zu verstärken, zu invertieren und mit einem Spannungsoffset zu versehen. Bei dem Differenzverstärker DV2 sind die Source-Anschlüsse T1S, T2S der Transistoren T1 bzw. T2 miteinander und mit einer Stromquelle verbunden, deren Strom 11 mit Hilfe eines Steueranschlusses T3G des Transistors T3 bestimmt wird. Der Drain-Anschluß T1D des Transistors T1 ist mit dem Steueranschluß T4G des Transistors T4 und einem Anschluß eines der beiden gleichwertigen Widerstände R1 verbunden; der Drain-Anschluß T2D des Transistors T2 ist mit dem Steueranschluß T5G des Transistors T5 und mit einem Anschluß des anderen der beiden gleichwertigen Widerstände R1 verbunden. Am jeweils anderen Anschluß der beiden gleichwertigen Widerstände R1 ist eine Spannung V_{Ghoch} angelegt, die mittels des Spannungsregelschaltkreises V_{CC} bestimmt wird. Durch Einstellung von V_{Ghoch}, der gleichwertigen Widerstände R1 und des Stroms I1 im Differenzverstärker DV2 lassen sich Hoch- und Niedrig-Pegel von Signalen VR1+ und VR1- exakt einstellen, die an den Drain-Anschlüssen T1D, T2D der Transistoren T1 bzw. T2 anliegen, wobei V_{Ghoch} den Hoch-Pegel und V_{Gniedrig} = V_{Ghoch}-R1·I1 den Niedrig-Pegel darstellt. Über diese Hoch- und Niedrig-Pegel aus dem Differenzverstärker DV2 kann die gewünschte Ausgangsspannung V_{Aus} am Ausgang der Ausgangsstufe eingestellt werden (unter Berücksichtigung der Gate-Source-Spannung V_{GS} der Transistoren T4 und T5).

Gemäß den LVDS-Spezifikationen soll ein Spannungsoffset bzw. -hub am Ausgang V_{Aus} der Ausgangsstufe 1,2 V betragen. Der Spannungshub von 350 mV ergibt sich aus einem für LVDS-Stufen geforderten Ausgangsstrom I_{Aus} von ca. 3,5 mA und einem für LVDS üblichen Lastwiderstand R_{Aus} von 100 Ohm. Der niedrigere Pegel des Ausgangssignals wird im Falle eines vollständig sperrenden Transistors T4 oder T5 durch den Spannungsabfall über der Stromquelle T8 festgelegt. Da in diesem Fall einer der Transistoren T4 oder T5 stromlos ist, bleibt der Ausgangswiderstand R_{Aus} hoch. Wird mit Hilfe einer geeigneten Spannung am Steueranschluß T8G des Transistors T8 der Strom 12 höher als V_{Aus}/R_{Aus} (3,5 mA) gewählt, bleibt der jeweilige Transistor T4 oder T5 (derjenige, mit dem jeweils niedrigeren Spannungspegel) teilweise leitend, sofern eine Spannung V_{Contr} = V_{Ghoch} - R1.I1 eingestellt wird. Ein entsprechender Ausgangswiderstand R_{Aus} kann eingestellt werden, indem der Stromquelle T8 ein Wert des Stroms 12 zugewiesen wird, der dafür sorgt, daß durch den jeweiligen Transistor T4 oder T5, an dem das niedrigere Steuersignal anliegt, der Strom I_{R} = 12 - I_{A} fließt. Somit definiert sich der Ausgangswiderstand R_{Aus} etwa über die Spannungsabfälle über den Source- und den Drain-Anschlüssen T4S, T5S, T4D, T5D der Transistoren T4 und T5 und die durch sie fließenden Teilströme I_{R}, I_{Aus}. Hierdurch läßt sich der für LVDS-Signale notwendige Ausgangswiderstand R_{Aus} von ca. 50 Ohm mittels der Dimensionierung der Transistoren T4 und T5 und der Eistellung des Stroms 12 realisieren.

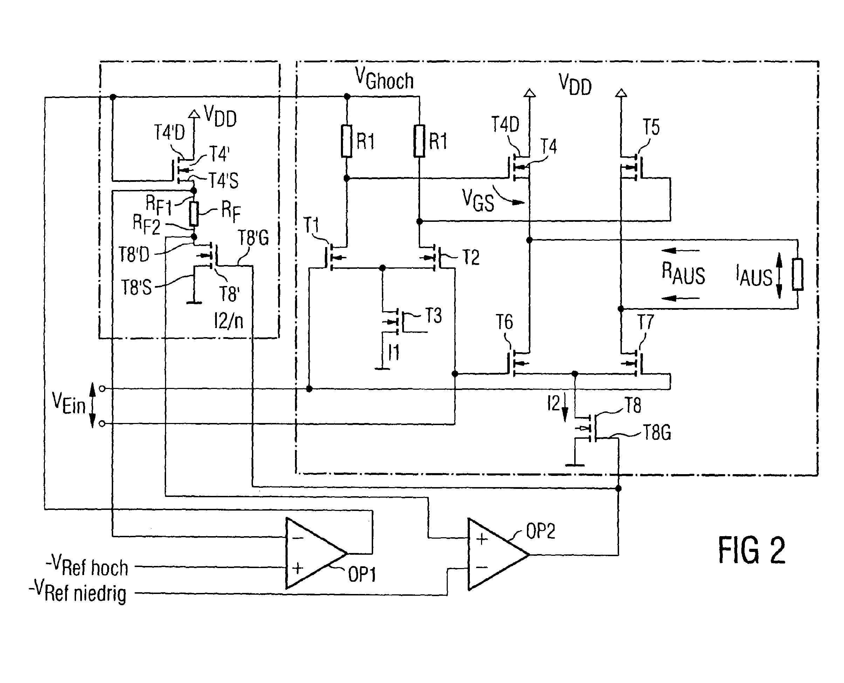

In Figur 2 ist zusätzlich zu der in Figur 1 dargestellten Ausgangsstufe ein Spiegelschaltkreis gezeigt. Der Spiegelschaltkreis bildet die Ausgangsstufe nach und liefert ein geeignetes V_{Ghoch} und zum Einstellen des Stroms 12 ein geeignetes Steuersignal an den Steueranschluß T8G der Stromquelle T8. Der Spiegelschaltkreis umfaßt einen Transistor T4', der vom gleichen Typ wie die Transistoren T4 oder T5 ist, einen Transistor T8', der vom gleichen Typ wie der die Stromquelle bildende Transistor T8 ist, einen Widerstand R_{F} von 100 Ohm, der gleich dem Lastwiderstand R_{AUS} ist, und zwei Operationsverstärker OP1 und OP2.

Der Drain-Anschluß T4'D des Transistors T4' ist mit einem Versorgungsspannungspotential V_{DD} verbunden. Der Source-Anschluß T4'S des Transistors T4' ist mit einem Anschluß des Widerstandes R_{F} verbunden. Der andere Anschluß des Widerstandes R_{F} ist mit dem Drain-Anschluß T8' D des Transistors T8' verbunden. Der Source-Anschluß T8'S des Transistors T8' ist an Masse angelegt. Ein Referenzspannungseingang für den Hoch-Pegel V_{Refhoch} ist an einen nicht-invertierenden Eingang des Operationsverstärkers OP1 angeschlossen. Der invertierende Eingang des Operationsverstärkers OP1 ist mit dem Source-Anschluß T4'S des Transistors T4' verbunden. Der Ausgang des Operationsverstärkers OP1 liegt an dem Steuereingang T4'G des Transistors T4' und als V_{Ghoch} an den beiden gleichwertigen Widerständen R1 des Differenzverstärkers DV2 an. Der Drain-Anschluß T8' D des Transistors T8' ist mit dem nicht-invertierenden Eingang des Operationsverstärkers OP2 verbunden, an dessen invertierendem Eingang die Referenzspannung für den Niedrig-Pegel V_{Refniedrig} angelegt ist. Der Ausgang dieses Operationsverstärkers OP2 ist mit dem Steuereingang T8G des Transistors T8, der die Stromquelle 12 bildet, und dem Steuereingang T8' G des Transistors T8' im Spiegelschaltkreis verbunden.

Der Spiegelschaltkreis arbeitet so, daß an dem Widerstand R_{F} die Referenzspannungen anliegen, so daß an einem R_{F1}-Anschluß des Widerstandes R_{F} V_{Refhoch} und an einem R_{F2}-Anschluß des Widerstandes R_{F} V_{Refniedrig} anliegt. Hierbei stellt der Operationsverstärker OP1 mit dem Transistor T4' ein Regelglied dar, das die Steuerspannung des Transistors T4', also V_{Ghoch}, so einstellt, daß das Spannungspotential an dem Anschluß R_{F1} des Widerstandes R_{F} exakt V_{Refhoch} entspricht. Da die beiden Transistoren T4 und T4' gleich und parallel geschaltet sind, liegt am Ausgangswiderstand R_{AUS} auch der Pegel V_{Refhoch} an. Ebenso stellen der Operationsverstärker OP2 und der Transistor T8' ein Regelglied dar, das das Spannungspotential an einem Anschluß R_{F2} des Widerstandes R_{F} dadurch exakt auf V_{Refniedrig} hält, daß über den Steueranschluß T8'G des Transistors T8' ein bestimmter Strom eingeprägt wird, der über dem Widerstand R_{F} einen definierten Spannungsabfall hervorruft. Die Spannung an dem Steueranschluß T8'G des Transistors T8' wird ebenfalls an den Transistor T8 der Stromquelle angelegt und bewirkt, daß durch den Transistor T8 der gleiche Strom fließt, wie durch den Transistor T8'.

In den Tabellen 1 und 2 sind Zustände und Pegel der Transistoren bzw. der Signale zusammengefaßt (zu Fig. 1):

**Tabelle 1:**

| Signal/ Transistor | V_{Ein+} | V_{Ein-} | T1 | T2 | VR1+ | VR1- | T4 |
|---|---|---|---|---|---|---|---|
| Zustand/ Pegel | Hoch | Niedrig | leitend | sperr. | Niedrig | Hoch | sperr.* |
| Zustand/ Pegel | Niedrig | Hoch | sperr. | leitend | Hoch | Niedrig | leitend |

| | | | | | | | |
|---|---|---|---|---|---|---|---|
| *) bzw. teilweise sperrend (vgl. Text) | | | | | | | |

**Tabelle 2:**

| Signal/ Transistor | T5 | T6 | T7 | V_{AUS+} | V_{AUS-} |
|---|---|---|---|---|---|
| Zustand/ Pegel | leitend | leitend | sperr. | Niedrig | Hoch |
| Zustand/ Pegel | sperr. | sperr. | leitend | Hoch | Niedrig |

Aufgrund der meist integrierten Aufbauweise können zwar annähernd gleichartige Transistoren auf einem Substrat hergestellt werden, eine Einstellung der Parameter ist jedoch aufgrund von Prozeßschwankungen nur mit großen Toleranzen möglich.

Mit Hilfe der beschriebenen Spiegelschaltung können V_{Ghoch} und die Steuerspannung des Transistors T8 und damit V_{Gniedrig} eingestellt werden, ohne die genauen Parameter der Transistoren zu kennen.

Um den Stromverbrauch der Spiegelschaltung zu minimieren, ist es möglich, die Transistoren sowie den Widerstand einem Skalierungsfaktor entsprechend zu skalieren.

## Patentansprüche

1. Elektronische Ausgangsstufe zur Verstärkung von differentiellen Eingangssignalen (V_{EIN}+, V_{EIN}-) mit einem geringen Spannungshub, insbesondere von hochfrequenten Eingangssignalen, die Ausgangsstufe aufweisend:
- einen ersten und einen zweiten Transistor (T6, T7), wobei ein erster Anschluß (T6S) des ersten und ein erster Anschluß (T7S) des zweiten Transistors (T6, T7) mit einer geregelten Stromquelle (T8) verbunden sind, ein Steueranschluß (T6G) des ersten Transistors (T6) mit einem ersten Eingangsanschluß und ein Steueranschluß (T7G) des zweiten Transistors (T7) mit einem zweiten Eingangsanschluß verbunden sind; und
- einen dritten und einen vierten Transistor (T4, T5), wobei ein erster Anschluß (T4D) des dritten Transistors (T4) und ein erster Anschluß (T5D) des vierten Transistors (T5) mit einem ersten Versorgungsspannungspotential (V_{DD}) verbunden sind, ein zweiter Anschluß (T4S) des dritten Transistors (T4) mit einem zweiten Anschluß (T6D) des ersten Transistors (T6) und einem ersten Ausgangsanschluß (V_{AUS}+) , ein zweiter Anschluß (T5S) des vierten Transistors (T5) mit einem zweiten Anschluß (T7D) des zweiten Transistors (T7) und einem zweiten Ausgangsanschluß (V_{AUS}-)verbunden sind, und an Steueranschlüsse (T4G, T5G) des dritten und des vierten Transistors (T4, T5) Ansteuersignale angelegt sind, die jeweils aus den verstärkten und mit einer Offsetspannung versehenen Eingangssignalen (V_{EIN}+, V_{EIN}-) gebildet sind;
wobei
- der Verlauf einer Spannungsänderung der Eingangssignale (V_{EIN}+, V_{EIN}-) und der Ansteuersignale an dem ersten und dem dritten Transistor (T6, T4) sowie an dem zweiten und dem vierten Transistor (T7, T5) jeweils gegenläufig ist und
- die Offset-Spannung der verstärkten Eingangssignale (V_{EIN}+, V_{EIN}- ) einstellbar ist.

2. Ausgangsstufe nach Anspruch 1, **dadurch gekenn-zeichnet**, daß mit Hilfe der Offsetspannung mindestens eine der Ausgangsspannungen eines Ausgangsanschlusses sowie mit Hilfe der Stromquelle (T8) und der Dimensionierung des dritten und des vierten Transistors (T4, T5) ein durch die Ausgangsanschlüsse (V_{AUS}+, V_{AUS}-) fließender Strom (I_{AUS}) und ein Ausgangswiderstand (R_{AUS}) einstellbar sind.

3. Ausgangsstufe nach einem der Ansprüche 1 oder 2, **da-durch gekennzeichnet**, daß jeweils der erste und der zweite Transistor (T6, T7) sowie der dritte und der vierte Transistor (T4, T5) eine gleiche Dimensionierung aufweisen.

4. Ausgangsstufe nach einem der vorangehenden Ansprüche, **da-durch gekennzeichnet**, daß der erste, der zweite, der dritte und der vierte Transistor (T4, T5, T6, T7) jeweils MOS-Transistoren sind.

5. Ausgangsstufe nach Anspruch 4, **dadurch gekenn-zeichnet**, daß mit Hilfe einer Differenzverstärkerschaltung die Offsetspannung so eingestellt ist, daß der dritte und der vierte Transistor (T4, T5) wenigstens teilweise leitend sind.

6. Ausgangsstufe nach einem der vorangehenden Ansprüche, **da-durch gekennzeichnet**, daß die Stromquelle (T8) so eingestellt ist, daß der Ausgangsstrom (I_{AUS}**)** etwa 3,5 mA beträgt.

7. Ausgangsstufe nach einem der vorangehenden Ansprüche, **da-durch gekennzeichnet**, daß der dritte und der vierte Transistor (T4, T5) so dimensioniert sind, daß der Ausgangswiderstand (R_{AUS}) zwischen dem ersten und dem zweiten Ausgangsanschluß (V_{AUS+}, V_{AUS}-) etwa 50 Ohm beträgt.

8. Ausgangsstufe nach einem der vorangehenden Ansprüche, **da-durch gekennzeichnet**, daß die Offset-spannung so eingestellt ist, daß zwischen dem ersten und dem zweiten Ausgangsanschluß (V_{AUS+}, V_{AUS-}) ein Spannungsoffsetwert von etwa 1,2V anliegt.

9. Ausgangsstufe nach einem der vorangehenden Ansprüche, **da-durch gekennzeichnet**, daß die Offset-Spannung durch einen Spannungsregelschaltkreis (V_{CC}) regelbar ist.

10. Ausgangsstufe nach den Ansprüchen 5 und 9, **dadurch gekennzeichnet, daß** die Regelung der Offset-Spannung durch eine Regelung der Spannungsversorgung des Differenzverstärkers erfolgt.

11. Ausgangsstufe nach einem der vorangehenden Ansprüche, **dadurch gekennzeichnet , daß** der Strom durch den ersten und den zweiten Ausgangsanschluß (V_{AUS+}, V_{AUS-}) und die Spannung zwischen dem ersten und dem zweiten Ausgangsanschluß (V_{AUS+}, V_{AUS-}) mit Hilfe einer Spiegelschaltung eingestellt ist, die als Eingangsanschlüsse zwei Referenzspannungen (V_{refhoch}, V_{Refniedrig}) aufweist und die Stromquelle (T8) und die Offsetspannung so regelt, daß ein niedriger Pegel an einem Ausgangsanschluß und ein hoher Pegel an dem jeweils anderen Ausgangsanschluß jeweils einer der Referenzspannungen entspricht.

12. Ausgangsstufe nach mindestens einem der Ansprüche 9 bis 11, **dadurch gekennzeichnet, daß** mit der geregelten Offset-Spannung der Highpegel der Ausgangsspannung eingestellt wird.

13. Ausgangsstufe nach einem der Ansprüche 9 bis 12, **dadu rch gekennzeichnet**, daß mittels des durch die Stromquelle (T8) eingeprägten Stroms (I₂) der Lowpegel der Ausgangsspannung eingestellt wird.

## Claims

1. Electronic output stage for amplifying differential input signals (V_{EIN+},V_{EIN-}) with a small voltage swing, particularly high-frequency input signals, whereby the output stage comprises:
-- first and second transistors (T6, T7); whereby a first terminal (T6S) of the first transistor (T6) and a first terminal (T7S) of the second transistor (T7) are connected to a controlled current source (T8); a control terminal (T6G) of the first transistor (T6) is connected to a first input terminal; and a control terminal (T7G) of the second transistor (T7) is connected to a second input terminal; and
-- third and fourth transistors (T4,T5); whereby a first terminal (T4D) of the third transistor (T4) and a first terminal (T5D) of the fourth transistor (T5) are connected to a first supply voltage potential (V_{DD}); a second terminal (T4S) of the third transistor (T4) is connected to a second terminal (T6D) of the first transistor (T6) and a first output terminal (V_{AUS+}) ; a second terminal (T5S) of the fourth transistor (T5) is connected to a second terminal (T7D) of the second transistor (T7) and a second output terminal (V_{AUS-}); and drive signals, which are in each case formed from the amplified input signals (V_{EIN+}, _{VEIN-})provided with an offset voltage, are applied at control terminals (T4G,T5G) of the third and fourth transistors (T4,T5);
whereby
-- a voltage change of the input signals (V_{EIN+}, V_{EIN-}) and drive signals behaves in opposite ways at the first and third transistors (T6,T4) and at the second and fourth transistors (T7,T5), respectively; and
-- the offset voltage of the amplified input signals (V_{EIN+},V_{EIN-}) is adjustable.

2. Output stage as claimed in claim 1, **characterized in that** at least one of the output voltages of an output terminal can be set with the aid of the offset voltage, and a current (I_{AUS}) flowing through the output terminals (V_{AUS}+V_{AUS}-) and an output resistance (R_{AUS}) can be set with the aid of the current source (T8) and the dimensioning of the third and fourth transistors (T4,T5).

3. Output stage as claimed in one of the claims 1 or 2, **characterized in that** the first and second transistors (T6,T7) and the third and fourth transistors (T4,T5), respectively, have equal dimensions.

4. Output stage as claimed in one of the preceding claims, **characterized in that** the first, second, third and fourth transistors (T4,T5,T6,T7) are MOS transistors, respectively.

5. Output stage as claimed in claim 4, **characterized in that** the offset voltage is set with the aid of a difference amplifier circuit so that the third and fourth transistors (T4,T5) are at least partly conductive.

6. Output stage as claimed in one of the preceding claims, **characterized in that** the current source (T8) is set such that the output current (I_{AUS}) equals some 3.5 mA.

7. Output stage as claimed in one of the preceding claims, **characterized in that** the third and fourth transistors (T4,T5) are dimensioned so that the output resistance (R_{AUS}) between the first and second output terminals (V_{AUS+}, V_{AUS-}) equals approx. 50 ohms.

8. Output stage as claimed in one of the preceding claims, **characterized in that** the offset voltage is set so that a voltage offset value of approx. 1.2 V stands between the first and second output terminals (V_{AUS+}, V_{AUS-}) .

9. Output stage as claimed in one of the preceding claims, **characterized in that** the offset voltage can be regulated by a voltage control circuit (V_{CC})

10. Output stage as claimed in claims 5 and 9, **characterized in that** the offset voltage is regulated by controlling the voltage supply of the difference amplifier.

11. Output stage as claimed in one of the preceding claims, **characterized in that** the current through the first and second output terminals (V_{AUS+},V_{AUS-}) and the voltage between the first and second output terminals (V_{AUS+},V_{AUS-}) are set with the aid of a mirror circuit, which comprises two reference voltages (V_{Refhoch}, V_{Refniedrig}) as input terminals and which controls the current source (T8) and the offset voltage in such a way that a low level at one output terminal and a high level at the other output terminal correspond to each of the reference voltages, respectively.

12. Output stage as claimed in at least one of the claims 9 to 11, **characterized in that** the high level of the output voltage is set with the regulated offset voltage.

13. Output stage as claimed in one of the claims 9 to 12, **characterized in that** the low level of the output voltage is set by means of the current (I₂) which is impressed by the current source (T8).

## Revendications

1. Etage de sortie électronique d'amplification de signaux (V_{EIN}+, V_{EIN}-) d'entrée différentiels avec une petite excursion de tension, notamment de signaux d'entrée en haute fréquence, l'étage de sortie comprenant :
- un premier et un deuxième transistor (T6, T7), un première borne (T6S) du premier et une première borne (T7S) du deuxième transistor (T6, T7) étant reliées à une source (T8) de courant asservie, une borne (T6G) de commande du premier transistor (T6) étant reliée à une première borne d'entrée et une borne (T7G) de commande du deuxième transistor (T7) à une deuxième borne d'entrée ; et
- un troisième et un quatrième transistor (T4, T5), une première borne (T4D) du troisième transistor (T4) et une première borne (T5D) du quatrième transistor (T5) étant reliées à un premier potentiel (V_{DD}) de tension d'alimentation, une deuxième borne (T4S) du troisième transistor (T4) étant reliée à une deuxième borne (T6D) du premier transistor (T6) et à une première borne (V_{AUS+}) de sortie, une deuxième borne (T5S) du quatrième transistor (T5) étant reliée à une deuxième borne (T7D) du deuxième transistor (T7) et à une deuxième borne (V_{AUS}-) de sortie et il est appliqué aux bornes (T4G, T5G) de commande du troisième et du quatrième transistor (T4, T5) des signaux de commande, qui sont formés respectivement à partir des signaux (V_{EIN}+, V_{EIN}-) d'entrée amplifiés et munis d'une tension d'offset ;
dans lequel
- les courbes d'une variation de tension des signaux (V_{EIN}+, V_{EIN}-) d'entrée et des signaux de commande sur le premier et troisième transistor (T6, T4) ainsi que sur le deuxième et le quatrième transistor (T7, T5) sont de sens opposés, respectivement et
- la tension d'offset des signaux (V_{EIN}+, V_{EIN}-) d'entrée amplifiés est réglable.

2. Etage de sortie suivant la revendication 1, **caractérisé en ce qu'**à l'aide de la tension d'offset au moins l'une des tensions de sortie d'une borne de sortie ainsi qu'à l'aide de la source (T8) de courant et du dimensionnement du troisième et du quatrième transistor (T4, T5) un courant (I_{AUS}) passant par les bornes (V_{AUS}+, V_{AUS}-) de sortie et une résistance (R_{AUS}) de sortie sont réglables.

3. Etage de sortie suivant la revendication 1 ou 2, **caractérisé en ce que** respectivement le premier et le deuxième transistor (T6, T7) ainsi que le troisième et le quatrième transistor (T4, T5) sont de même dimension.

4. Etage de sortie suivant l'une des revendications précédentes, **caractérisé en ce que** le premier, le deuxième, le troisième et le quatrième transistor (T4, T5, T6, T7) sont respectivement des transistors MOS.

5. Etage de sortie suivant la revendication 4, **caractérisé en ce qu'**à l'aide d'un circuit amplificateur différentiel la tension d'offset est réglée de façon à ce que le troisième et le quatrième transistor (T4, T5) soient, au moins en partie, passants.

6. Etage de sortie suivant l'une des revendications précédentes, **caractérisé en ce que** la source (T8) de courant est réglée de façon à ce que le courant (I_{AUS}) de sortie soit d'environ 3,5 mA.

7. Etage de sortie suivant l'une des revendications précédentes, **caractérisé en ce que** le troisième et le quatrième transistor (T4, T5) ont des dimensions telles que la résistance (R_{AUS}) de sortie entre la première et la deuxième borne (V_{AUS}+, V_{AUS}-) de sortie est d'environ 50 ohms.

8. Etage de sortie suivant l'une des revendications précédentes, **caractérisé en ce que** la tension d'offset est réglée de façon à ce qu'il s'applique entre la première et la deuxième borne (V_{AUS}+, V_{AUS}-) de sortie une valeur d'offset de tension d'environ 1,2 V.

9. Etage de sortie suivant l'une des revendications précédentes, **caractérisé en ce que** la tension d'offset peut être réglée par un circuit (V_{CC}) de réglage de tension.

10. Etage de sortie suivant les revendications 5 et 9, **caractérisé en ce que** la régulation de la tension d'offset s'effectue par une régulation de l'alimentation en tension de l'amplificateur différentiel.

11. Etage de sortie suivant l'une des revendications précédentes, **caractérisé en ce que** le courant passant par la première et la deuxième borne (V_{AUS}+, V_{AUS}-) de sortie et la tension entre la première et la deuxième borne (V_{AUS}+, V_{AUS}-) de sortie est réglé à l'aide d'un circuit miroir qui a comme borne d'entrée de tension (V_{refhoch}, V_{refniedrig}) de référence et la source (T8) de courant et la tension d'offset sont réglées de façon à ce qu'un niveau bas sur une borne de sortie et un niveau haut sur l'autre borne de sortie correspondent respectivement à l'une des tensions de référence.

12. Etage de sortie suivant au moins l'une des revendications 9 à 11, **caractérisé en ce que en ce que** le niveau haut de la tension de sortie est réglé par la tension d'offset asservie.

13. Etage de sortie suivant l'une des revendications 9 à 12, **caractérisé en ce que** le niveau bas de la tension de sortie est réglé au moyen du courant (I₂) imprimé par la source (T8) de courant.
